(19) **Europäisches Patentamt / European Patent Office / Office européen des brevets**

(11) **EP 1 554 806 B1**

(12) **FASCICULE DE BREVET EUROPEEN**

(45) Date de publication et mention
de la délivrance du brevet:
**25.03.2009 Bulletin 2009/13**

(21) Numéro de dépôt: **03775489.2**

(22) Date de dépôt: **17.10.2003**

(51) Int Cl.:
**H03L 7/08** $^{(2006.01)}$

(86) Numéro de dépôt international:
**PCT/FR2003/003064**

(87) Numéro de publication internationale:
**WO 2004/036753 (29.04.2004 Gazette 2004/18)**

(54) **PROCEDE D'ESTIMATION DE LA PHASE DANS UN SYSTEME DE COMMUNICATION NUMERIQUE ET BOUCLE A VERROUILLAGE DE PHASE**

VERFAHREN ZUR PHASENSCHÄTZUNG IN EINEM DIGITALEN ÜBERTRAGUNGSSYSTEM UND PHASENREGELKREIS

PHASE ESTIMATION METHOD IN A DIGITAL AND PHASE LOCKED LOOP COMMUNICATION SYSTEM

(84) Etats contractants désignés:
**DE FR GB IT**

(30) Priorité: **17.10.2002 FR 0212900**

(43) Date de publication de la demande:
**20.07.2005 Bulletin 2005/29**

(73) Titulaire: **STMicroelectronics S.A.
92120 Montrouge (FR)**

(72) Inventeurs:
• **BROSSIER, Jean-Marc
F-38400 Saint Martin d'Hères (FR)**
• **LEHMANN, Frédéric
San Diego, CA 92103 (US)**

(74) Mandataire: **Schuffenecker, Thierry
120 Chemin de la Maure
06800 Cagnes sur Mer (FR)**

(56) Documents cités:
**US-A- 4 849 991         US-A1- 2001 043 102**

**Description**

**Domaine technique de l'invention**

La présente invention concerne le domaine des communications numériques et notamment un procédé d'estimation de la phase dans un système de communication numérique et une boucle à verrouillage de phase.

**Etat de la technique**

Dans un système de communication numérique comportant un émetteur et un récepteur, le signal numérique à transmettre - en général une suite de symboles- est converti avant transmission sous la forme d'un signal analogique à temps continu qui est alors transmis par un milieu de propagation physique, l'air ou tout autre milieu physique de propagation. Lorsque le signal est reçu par le récepteur, il est alors traité et converti sous une forme numérique au moyen d'un échantillonnage approprié, lequel intervient en général à une fréquence $f_e$ que l'on cherche en général à rendre synchrone par rapport à la fréquence $f_s$ à l'émission des symboles. Malheureusement les horloges se trouvant dans les circuits oscillateurs équipant l'émetteur et le récepteur ne sont jamais synchrones et il faut alors compenser toute dérive en fréquence entre ces horloges de manière à pouvoir traiter convenablement le signal reçu et en extraire les symboles émis.

Cette dérive en fréquence affectant les oscillateurs à l'émission et à la réception engendre un déphasage parasite sur les observations du signal en sortie du démodulateur complexe situé dans le récepteur. D'autres facteurs contribuent à accentuer ce déphasage parasite. En premier lieu, on peut citer le temps que prend le signal numérique pour traverser le milieu de propagation. En second lieu tout mouvement de l'émetteur par rapport au récepteur est source d'effet Doppler et tend, lui également, àintroduire un déphasage perturbateur.

En se référant au modèle en bande de base, les observations $Y_k$ en sortie du démodulateur complexe situé dans le récepteur peuvent être exprimées par la formule suivante: sur

$$Y_k = a_k \ e^{\ i \xi_k} \ + \ \eta_k$$

Avec $a_k$ correspondant aux symboles émis, $\xi_k$ étant le déphasage parasite et $\eta_k$ étant un bruit supplémentaire.

Des techniques sont déjà connues - basées sur des circuits estimateurs de phase - pour estimer ce déphasage parasite $\xi_k$ et permettre sa correction.

Les estimateurs de phase les plus sophistiqués, qui traitent simultanément des pans entiers d'observations reçues s'appuient sur des traitements numériques extrêmement lourds : le filtrage particulaire, les méthodes de Monte-Carlo par chaîne de Markov etc... En pratique, de telles techniques s'avèrent irréalisables à mettre en oeuvre sur un plan pratique en raison de la puissance de calcul considérable devant être mises en jeu.

Le brevet US 4,849,991 décrit une méthode et un circuit pour déterminer la synchronisation symbole pour de la transmission radio de type TDMA.

Pour cette raison, on oppose à la complexité de ces estimateurs de phase la simplicité de mise en oeuvre des boucles à verrouillage de phase qui traitent séquentiellement les observations reçues les unes après les autres et non par pans entiers d'observations reçues. Classiquement une boucle à verrouillage de phase est basée sur un algorithme numérique itératif permettant d'approcher une valeur estimée de la phase. Si traditionnellement, les boucles à verrouillage de phase sont réalisées au moyen de circuits analogiques, le même traitement est aujourd'hui entièrement numérique il est à noter que ce traitement numérique dépend étroitement du type de modulation envisagée.

A titre d'exemple, considérons le cas d'une modulation à déplacement de phase à deux états (MDP2), connue dans la littérature anglo-saxonne sous l'appellation *Binary Phase Shift Keying BPSK*. Dans cette modulation MDP2 ou BPSK, les symboles $a_k$ qui sont transmis sont égaux à -1 ou +1. Du fait du déphasage parasite évoqué précédemment, on n'obtient plus -1 et +1 en sortie du démodulateur complexe, mais ces mêmes valeurs affectées d'un déphasage. Une boucle à verrouillage de phase bien connue pour prendre en charge la correction de ce déphasage est la boucle dite de COSTAS qui prend appui sur l'utilisation d'un algorithme du gradient associé à une fonction de coût J donnée par la formule :

$$J(\varphi) = E \ ( \ | y^2_k \ e^{-i2\varphi} - 1 \ |^2 \ )$$

Dans laquelle E étant l'opérateur Espérance mathématique.

L'application de l'algorithme du gradient à la variable φ permet de faire converger l'algorithme vers la phase estimée :

$$\varphi_k = \varphi_{k-1} - \gamma \partial J(\varphi)/\partial\varphi \mid \varphi = \varphi_{k-1}$$

La boucle de Costas est finalement obtenue en supprimant l'espérance mathématique : c'est l'algorithme du gradient stochastique pour minimiser la fonction de coût J.

On connaît d'autres formules pour d'autres types de modulation et notamment la modulation en quadrature, également dénommée Quadrature Amplitude Modulation à quatre états ou 4QAM. D'une manière générale, quelle que soit le type de modulation employé, les boucles de verrouillages de phase sont construites sur une formule générale du type :

$$\varphi_k = \varphi_{k-1} - \gamma F(Y_k, \varphi_{k-1})$$

avec F étant une fonction dépendant étroitement de la modulation considérée.

Typiquement, comme on le voit sur la formule précédente, toutes les boucles consistent à calculer la phase $\varphi_k$ en fonction de l'élément précédent $\varphi_{k-1}$ et d'une fonction F des deux éléments $Y_k$ et $\varphi_{k-1}$. Il est à noter que, dans cette formule, en fonction du type de déphasage à corriger, on peut avoir recours à une correction sophistiquée au niveau du paramètre $\gamma$ et notamment prévoir la mise en oeuvre d'un filtre correcteur du second ordre (proportionnel intégral), voire d'un ordre supérieur.

Toutes les boucles à verrouillage de phase connues - reprenant classiquement le modèle analogique traditionnellement connu - présentent une même limitation. L'évaluation de la phase $\varphi_k$ est essentiellement basée à partir de la valeur précédente $\varphi_{k-1}$ et à partir d'une fonction d'une ou plusieurs observations passées. De ce fait l'estimation de la phase reste imparfaite et, par suite, sa correction.

Il convient d'améliorer le modèle de la boucle à verrouillage de phase afin d'accroître la précision de l'estimation et l'efficacité de la correction.

**Exposé de l'invention**

Un objet de invention est une nouvelle structure de boucle à verrouillage de phase permettant d'accroître la précision de l'estimation de la phase par rapport à une boucle classique.

un autre objet de l'invention consiste à proposer un procédé d'estimation de phase pour un récepteur numérique parfaitement adapté au traitement dun signal numérique dans un récepteur doté d'un système de correction d'erreurs.

Selon l'invention, ces objets sont réalisés au moyen d'un procédé d'estimation de phase et d'un dispositif de boucle à verrouillage de phase.

L'invention propose un procédé d'estimation d'une phase dans un système de communication numérique tel que défini dans la revendication 1 comportant les étapes suivantes :

- réception et mémorisation d'un bloc d'observations $Y_k$ ;
- exécution d'au moins une boucle à verrouillage de phase sur une séquence prédéterminée d'observations extraites dudit bloc, suivie d'une second boucle à verrouillage de phase traitant les mêmes observations dans une séquence inverse..

L'invention propose également un dispositif de boucle à verrouillage de phase pour un récepteur numérique tel que défini dans la revendication 7 comportant:

- des moyens pour recevoir et stocker des observations par bloc ;
- une première boucle de verrouillage de phase permettant de générer une première valeur intermédiaire;
- une seconde boucle de verrouillage de phase permettant de générer une seconde valeur intermédiaire ;
- des moyens pour dériver desdites première et seconde valeur intermédiaire une valeur estimée de la phase.

En réalisant un traitement par bloc au niveau de la boucle à verrouillage de phase - lequel traitement par bloc n'intervient classiquement qu'en aval, au niveau des codes correcteurs d'erreur, on améliore sensiblement l'estimation de la phase tout en conservant la grande simplicité de mise en oeuvre des boucles traditionnelles à verrouillage de phase.

On peut en particulier briser le lien chronologique entre les observations et l'algorithme itératif qui est mis en oeuvre par la boucle à verrouillage de phase. L'invention consiste à rapprocher deux concepts a priori antinomiques, à savoir le traitement par bloc et la boucle de phase. Dans l'approche classique, on conçoit, la boucle de phase comme un traitement itératif, prenant appui sur les observations passées pour en dériver une estimation de la phase à un instant donné. La présente invention transgresse radicalement cette approche et réalise un procédé dans lequel, une fois un bloc d'observations mémorisées, l'estimation de la phase peut être effectuée à partir d'une ou plusieurs boucles de phase opérant sur toute séquence quelconque d'observations au sein du même bloc.

De préférence, on réalise une première boucle à verrouillage de phase sur une autre séquence d'observations extraites du même bloc. Le résultat de chacune des boucles est combiné pour fournir une estimation affinée de la phase à chaque instant d'échantillonnage.

Comme on le voit, en combinant le traitement par bloc et la simplicité des boucles à verrouillage de phase, on peut sensiblement améliorer la précision de l'estimation de phase et, par suite, la correction. En effet, le traitement par bloc permet en effet de tenir compte, pour le calcul de $\varphi_k$ non seulement des observations antérieures mais également des observations postérieures au sein d'un même bloc. La précision de la boucle de verrouillage de phase en est alors considérablement améliorée.

Bien que le procédé introduise un retard de traitement lié à la mémorisation d'un bloc complet d'observations avant l'estimation de la phase pour chacune des observations $Y_k$ considérées, ce retard n'est pas préjudiciable et est parfaitement adapté à l'usage de certains codes correcteurs d'erreurs, comme les turbos codes ou les *codes en* blocs.

Préférentiellement le traitement par bloc sera effectué au moyen d'une première boucle de phase opérant dans le sens chronologique des observations, et d'une seconde boucle de phase opérant en sens inverse.

Dans un mode de réalisation préféré, la seconde boucle à verrouillage de phase est initialisée avec une valeur qui est celle fournie par la première boucle en fin d'itération.

**Description des dessins**

D'autres caractéristiques, buts et avantages de l'invention apparaîtront à la lecture de la description et des dessins ci-après, donnés uniquement à titre d'exemples non limitatifs. Sur les dessins annexés :

La figure 1 illustre le schéma de principe du procédé d'estimation d'une phase selon l'invention.

La figure 2 illustre l'effet d'un déphasage pour une modulation BPSK.

La figure 3 illustre le mode de réalisation préféré basé sur l'emploi de deux boucles à verrouillage de phase opérant en sens contraire.

La figure 4 illustre l'application du procédé de la figure 1 à une modulation 4-PSK ou 4-QAM.

La figure 5 illustre l'application de l'invention à une modulation de type BPSK à deux états.

**Description d'un mode de réalisation préféré**

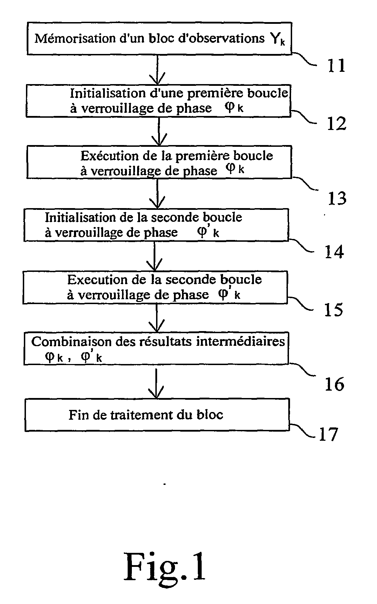

En relation avec la figure 1, on décrit à présent le procédé général d'estimation de la phase, lequel convient pour tout type de modulation, qu'il s'agisse d'une modulation BPSK, 4-QAM etc.... Le procédé comporte une première étape 11 au cours de laquelle un ensemble de n+1 observations (par hypothèse $Y_0$ à $Y_n$) en sortie du démodulateur complexe est réceptionné et mémorisé au sein d'un bloc de n+1 observations. Typiquement, on pourra envisager un bloc de 1000 à 10 000 observations et l'homme du métier choisira un nombre en fonction de l'application et du type de modulation envisagée.

Une fois la mémorisation du bloc effectuée, on réalise une première boucle à verrouillage de phase qui va opérer sur une séquence prédéterminée d'observations du bloc. Typiquement, on pourra considérer toute séquence quelconque et plus particulièrement une séquence chronologique d'observations $Y_k$, suivant l'ordre de réception des données. La réalisation concrète d'une boucle à verrouillage de phase ne pose aucune difficulté en soi et, pour des raisons de simplicité d'exposé, celle-ci ne sera pas développée plus avant. On se bornera à dire que, en fonction du type de modulation utilisé, on mettra en oeuvre un algorithme itératif suivant la formule générale rappelée précédemment.

$$\varphi_k = \varphi_{k-1} - \gamma \; F(Y_k, \varphi_{k-1}) \quad \text{avec } k = 1 \text{ à } n$$

Dans une étape 12, on procède à l'initialisation de la première boucle à verrouillage de phase. Typiquement, cette initialisation permet de fixer les premières valeurs de l'algorithme itératif, et notamment la première valeur $\varphi_0$. De préférence, lorsque la phase présente une continuité d'un bloc à l'autre, on initialisera d'une manière avantageuse la première boucle en prenant en considération la dernière valeur estimée au bloc précédent. Pour une boucle d'ordre supérieur à 1, plusieurs paramètres devront être fixés et, à nouveau, on pourra avantageusement tirer profit de toute continuité exploitable.

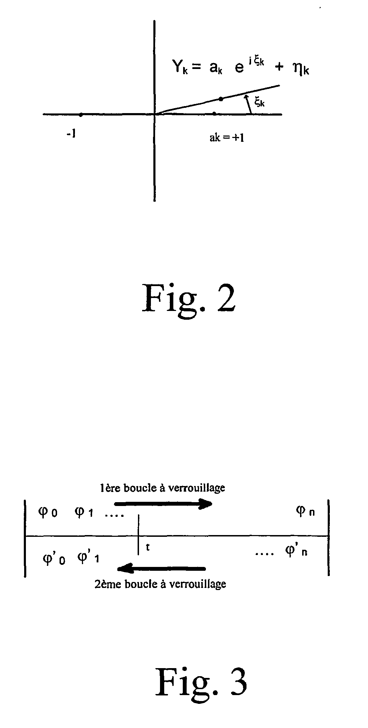

Dans une étape 13, on exécute la première boucle à verrouillage de phase de manière à construire la séquence $\varphi_0$, $\varphi_1$, $\varphi_2$, $\varphi_3$ ...., $\varphi_n$, comme cela est illustré dans la figure 3 par la flèche allant de la gauche vers la droite.

Dans une étape 14, on initialise à présent une seconde boucle à verrouillage de phase allant dans le sens opposé à la première (représentée sur la figure 2 par la flèche dirigée de la droite vers la gauche). De préférence, on initialise la première valeur de la seconde boucle, à savoir $\varphi'_n$ avec la dernière valeur numérique $\varphi_n$ calculée par la première boucle à verrouillage de phase.

Dans une étape 15, on exécute la seconde boucle à verrouillage de phase de manière à construire la séquence $\varphi'_{n-1}$, $\varphi'_{n-2}$, $\varphi'_2$, $\varphi'_1$ ...., $\varphi'_0$ calculée dans le sens inverse à précédemment.

$$\varphi'_k = \varphi'_{k+1} - \gamma \; F(Y_k, \varphi'_{k+1}) \quad \text{avec } k = n-1 \text{ à } 0$$

Dans une étape 16, on combine les résultats intermédiaires produits par la première et par la seconde boucle à verrouillage de phase de manière à produire la phase estimée $\varphi''_k$ suivant la formule

$$\varphi''_k = G(\varphi_k, \varphi'_k)$$

dans laquelle la fonction G est adaptée au type de modulation considéré. Dans un mode de réalisation particulier, on choisira G de manière à générer une somme pondérée sous la forme :

$$\varphi''_k = A \times \varphi_k + B \times \varphi'_k$$

De préférence, on pourra d'ailleurs choisir des coefficients variables $A_k$ et $B_k$ de manière à privilégier l'une des deux boucles à verrouillage de phase en fonction de k. En effet, on pourra avantageusement choisir les « poids » de la somme pondérée de manière à privilégier la première boucle dans la partie droite du bloc de la figure 2 et, inversement, ajouter plus de poids à la seconde boucle dans la partie la plus à gauche du bloc. Ainsi, on privilégie toujours la boucle ayant effectué le plus d'itérations et pourra prétendre à une plus grande précision dans le calcul de la phase.

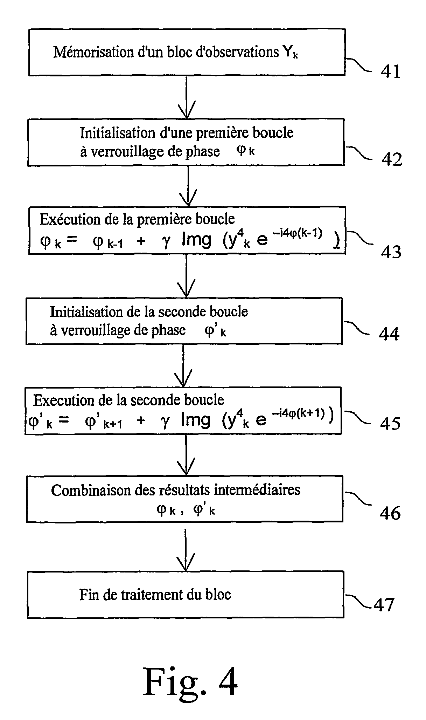

En relation avec la figure 4, on décrit à présent l'application du procédé général de la figure 1 à une modulation de type 4-BPSK ou 4-QAM . Dans une modulation de ce type, on transmet les symboles complexes $a_k$ qui sont respectivement -1, +1, -i et +i. Le procédé débute par une étape 41 consistant, comme précédemment, en la réception et la mémorisation d'un bloc d'observations reçues du démodulateur complexe.

Dans une étape 42, on procède à l'initialisation de la première boucle à verrouillage de phase adaptée pour une modulation 4-QAM :

$$\varphi_k = \varphi_{k-1} + \gamma \; \text{Img}(y_k^4 \, e^{-i4\varphi(k-1)})$$

dans laquelle IMG correspond à la partie imaginaire du nombre complexe.

Il est à noter que, en pratique, on pourra prévoir l'emploi d'un filtre numérique sophistiqué pour le calcul du

facteur $\gamma$ en fonction de modèle du déphasage que l'on souhaitera corriger. Pour des déphasages simples, on pourra s'accommoder d'un correcteur proportionnel simple alors que dans des cas plus complexes, on pourra avantageusement recourir à un correcteur intégral, voire à un filtre d'ordre supérieur.

Pour l'initialisation de la boucle à verrouillage de phase, on donnera la première valeur de $\varphi_0$. De préférence, le filtre $\gamma$ pourra être réalisé au moyen d'un filtre numérique d'un ordre 2, par exemple du second ordre suivant la formule ci-après :

$$\gamma \;=\; \gamma_1 + \gamma_2 / (1 + z^{-1})$$

et que l'on initialisera en tenant compte de tous les facteurs de continuité exploitables.

Dans une étape 43, on exécute la première boucle à verrouillage de phase de manière à construire toute la séquence $\varphi_0$, $\varphi_1$, $\varphi_2$, $\varphi_3$ ...., $\varphi_n$.

Dans une étape 44, on initialise à présent une seconde boucle à verrouillage de phase de COSTAS avec la dernière valeur calculée par la première boucle et, dans une étape 45 on exécute cette boucle pour construire la séquence $\varphi'_{n-1}$, $\varphi'_{n-2}$, $\varphi'_2$, $\varphi'_1$ ...., $\varphi'_0$ calculée dans le sens inverse à précédemment.

$$\varphi'_k = \varphi'_{k+1} + \gamma \; \text{Img} \; (y^4_k \, e^{-i4\varphi(k+1)}) \qquad k=n-1...0$$

Les deux résultats intermédiaires sont alors combinés dans une étape 46 de manière à générer l'estimation du déphasage $\varphi''_k$, de préférence suivant la formule

$$\varphi''_k = G(\varphi_k, \varphi'_k)$$

Dans une étape 47, le procédé achève le traitement du bloc courant.

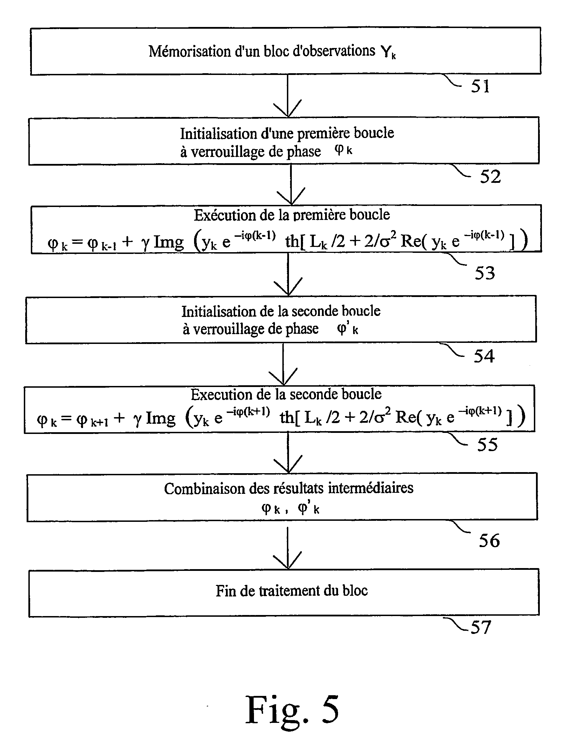

Pour illustrer la généralité de l'invention, on va montrer à présent en référence à la figure 5 que l'invention peut contribuer a améliorer considérablement l'estimation de phase dans une modulation de type BPSK.

Le procédé démarre, une fois encore, par la réception et la mémorisation d'un bloc de d'observations $Y_k$ dans une étape 51.

Dans une étape 52, on procède à l'initialisation de la première boucle à verrouillage de phase adaptée pour une modulation BPSK. D'une manière particulièrement avantageuse et nouvelle, on combine cette première boucle à verrouillage de phase avec l'exploitation d'informations statistiques portant sur les symboles $a_k$ transmis dans cette modulation BPSK . On réalise à cet effet une boucle à verrouillage de phase suivant la formule :

$$\varphi_k = \varphi_{k-1} + \gamma \; \text{Img} \; \left( y_k \, e^{-i\varphi(k-1)} \; \text{th}[\, L_k / 2 + 2/\sigma^2 \, \text{Re}(\, y_k \, e^{-i\varphi(k-1)} \,] \,) \right)$$

dans laquelle :

th : étant l'opérateur tangeante hyperbolique,
Re: étant l'opérateur renvoyant la partie réelle d'un nombre complexe,
$\sigma^2$: étant la variance du bruit;

et

$$L_k = \text{Ln} \; \left[ \; p(a_k=1) / p(a_k = -1) \; \right]$$

et Ln étant le logarithme népérien. $p(a_k = 1)$ est la probabilité pour que le symbole $a_k$ soit égal à +1 et $p(a_k = -1)$ est la probabilité pour que le symbole $a_k$ soit égal à -1,

Comme précédemment, on pourra prévoir l'emploi d'un filtre numérique du second ordre - voire d'un ordre supérieur - pour le facteur $\gamma$.

Dans une étape 53, on exécute la première boucle à verrouillage de phase de manière à construire la séquence $\varphi_0, \varphi_1, \varphi_2, \varphi_3 ...., \varphi_n$.

Dans une étape 54, on initialise à présent une seconde boucle à verrouillage de phase construite comme précédemment, en tenant compte d'informations statistiques portant sur les symboles. avec la dernière valeur calculée par la première boucle et, dans une étape 55 on exécute cette boucle pour construire la séquence $\varphi'_n$-, $\varphi'_{n-2}$, $\varphi'_2$, $\varphi'_1$ .... , $\varphi'_0$ calculée dans le sens inverse à précédemment.

$$\varphi_k = \varphi_{k+1} + \gamma\, \mathrm{Img}\, \left( y_k\, e^{-i\varphi(k+1)}\, \mathrm{th}[\, L_k/2 + 2/\sigma^2\, \mathrm{Re}(\, y_k\, e^{-i\varphi(k+1)}\, ]\, \right)$$

Deux variantes de réalisation sont encore possibles. Si la puissance de bruit reste faible, on peut approximer la fonction tangente hyperbolique par la fonction signe. On obtient alors la formule suivante typique d'une boucle à remodulation (désignée sous l'appellation anglo-saxonne *decision feeback l*oop) au terme additif $L_k/2$ près.

On peut noter que, dans le cas contraire lorsque la puissance de bruit est importante, l'opérateur tangente hyperbolique peut s'approximer par la fonction identité et l'on retombe alors sur le formule d'une boucle de COSTAS (au terme additif $L_k/2$ près).

Dans une étape 56, on combine les deux résultats intermédiaires obtenues des deux boucles à verrouillage de phase de manière à générer l'estimation du déphasage $\varphi''_k$, de préférence suivant la formule

$$\varphi''_k = G(\varphi_k, \varphi'_k)$$

Comme précédemment, le traitement du bloc courant s'achève dans une étape 57.

Les deux exemples précédents montrent que le procédé suivant l'invention s'applique à tout type de modulation et à tout type de boucle à verrouillage de phase. Il est clair que l'homme du métier pourra réaliser toutes les adaptations appropriées, voire même combiner avantageusement le traitement par bloc de la boucle de phase réalisé très en amont avec tous les traitements ultérieurs réalisés en aval, qu'il s'agisse de traitement de codes correcteurs d'erreur, turbocodes etc...

**Revendications**

1. Procédé d'estimation d'une phase dans un système de communication numérique comportant les étapes suivantes :

   - réception et mémorisation (11) d'un bloc d'observations $Y_k$ ;

   **caractérisé en ce qu'**il comporte les étapes suivantes :

   - exécution (12, 13) d'une première boucle de verrouillage de phase sur une séquence prédéterminée d'observations extraites dudit bloc dans le but de générer une première valeur intermédiaire ;
   - exécution (14, 15) d'une seconde boucle de verrouillage de phase sur lesdites observations dans une séquence inverse dans le but de générer une seconde valeur intermédiaire ;
   - combinaison (16) desdites première et seconde valeurs intermédiaires pour générer une valeur estimée de la phase.

2. Procédé selon la revendication 1 **caractérisé en ce que** ladite première boucle est exécutée sur la séquence d'observations dans l'ordre chronologique d'apparitions, et **en ce que** la seconde séquence est exécutée sur la séquence inverse.

3. Procédé selon la revendication 2 **caractérisé en ce que** la seconde boucle à verrouillage de phase est initialisée à partir de la dernière valeur calculée par ladite première boucle à verrouillage de phase.

4. Procédé selon la revendication 3 **caractérisé en ce qu'**il comporte les étapes suivantes :

   - réception et mémorisation d'un bloc d'observations $Y_k$ avec k variant de 0 à n ;
   - initialisation d'une première boucle de phase à partir des observations Yk reçues ; i
   - exécution de ladite première boucle de phase suivant une formule :

$$\varphi_k = \varphi_{k-1} - \gamma \ F(Y_k, \varphi_{k-1}) \ \text{avec } k = 1 \ \text{à } n$$

avec F étant une fonction adaptée au type de modulation considérée
   - initialisation d'une seconde boucle de phase à partir des observations Yk avec k variant de n à 0 :
   - exécution de ladite seconde boucle à verrouillage de phase suivant une formule :

$$\varphi'_k = \varphi'_{k+1} - \gamma \ F(Y_k, \varphi'_{k+1}) \ \text{avec } k = n-1 \ \text{à } 0$$

   - combinaison des résultats produits par lesdites première et seconde boucle de manière à générer une valeur estimée de la phase.

5. Procédé selon l'une quelconque des revendications précédentes **caractérisé en ce que** la modulation est de type BPSK avec une boucle à verrouillage de phase définie par

$$\varphi_k = \varphi_{k-1} + \gamma \ \text{Img} \left( y_k \ e^{-i\varphi(k-1)} \ \text{th}[L_k/2 + 2/\sigma^2 \ \text{Re}(y_k \ e^{-i\varphi(k-1)}] \right)$$

dans laquelle:

   th : étant l'opérateur tangente hyperbolique,
   Re: étant l'opérateur renvoyant la partie réelle d'un nombre complexe,
   $\sigma^2$: étant la variance du bruit;

et

$$L_k = \text{Ln} \left[ p(a_k = 1) / p(a_k = -1) \right]$$

et Ln étant le logarithme népérien, $p(a_k = 1)$ la probabilité pour que le symbole $a_k$ soit égale à +1 et $p(a_k = -1)$ la probabilité pour que le symbole $a_k$ soit égale à -1.

6. Procédé selon la revendication 5 **caractérisé en ce que** ledit facteur $\gamma$ est réalisé au moyen d'un filtre numérique d'ordre 2 ou supérieur.

7. Dispositif de boucle à verrouillage de phase pour un récepteur numérique comportant :

   - des moyens pour recevoir et stocker des observations par bloc ;

   **caractérisé en ce qu'**il comporte :

   - une première boucle de verrouillage de phase opérant sur une séquence d'observations dudit bloc permettant de générer une première valeur intermédiaire ;
   - une seconde boucle de verrouillage de phase opérant en sens inverse sur la même séquence d'observations dudit bloc permettant de générer une seconde valeur intermédiaire ;
- des moyens pour dériver desdites première et seconde valeurs intermédiaires une valeur estimée de la phase.

**8.** Dispositif de boucle à verrouillage de phase selon la revendication 7 **caractérisé en ce que** ladite première et seconde boucle à verrouillage de phase sont réalisées au moyen de la formule :

$$\varphi_k = \varphi_{k-1} - \gamma \, F(\, Y_k \,, \varphi_{k-1} \,) \ \text{avec } k = 1 \text{ à } n$$

ou

$$\varphi_k = \varphi_{k+1} - \gamma \, F(\, Y_k \,, \varphi_{k+1} \,) \ \text{avec } k = n-1 \text{ à } 0$$

avec F étant une fonction adaptée au type de modulation considérée

**9.** Dispositif selon la revendication 8 **caractérisé en ce que** première valeur calculée par ladite seconde boucle est déterminée par le dernier calcul réalisé par la dite première boucle à verrouillage de phase.

## Claims

**1.** A method for estimating the phase in a digital communication system comprising the steps of:

- receiving and storing (11) a block of observations $Y_k$ ;

**characterized in that** it comprises the following steps:

- executing (12, 13) a first phase locked loop on a predetermined sequence of observations from said block in order to generate a first intermediate value;
- executing (14, 15) a second phase locked loop on said observations in a inverse sequence in order to generate a second intermediate value;
- combining (16) said first and second intermediate values to generate a phase estimate.

**2.** The method according to claim 1 **characterized in that** said first loop executes on a sequence of observations according to their chronological order of occurrence, and that said second loop executes on the inverse sequence.

**3.** The method according to claim 2 **characterized in that** said second phase locked loop is initialized to the last value calculated by said first phase locked loop.

**4.** The method according to claim 3 **characterized in that** it comprises the steps of:

- receiving and storing a block of observations $Y_k$, with k varying from 0 to n;
- initializing a first phase locked loop from received observations $Y_k$;
- executing said first phase locked loop according to the following formula:

$$\varphi_k = \varphi_{k-1} - \gamma \, F(Y_k, \varphi_{k-1}) \ \text{with } k = 1 \text{ to } n$$

where F is a function adapted to the type of modulation considered

- initializing a second phase locked loop from observations $Y_k$, with k varying from n to 0;
- executing said second phase locked loop (PLL) according to the following formula:

$$\varphi'_k = \varphi'_{k+1} - \gamma\, F\, (Y_k\, ,\, \varphi'_{k+1}\, )\ \text{with } k = n\text{-}1 \text{ to } 0$$

- combining the results produced by said first and second loops to generate a phase estimate.

**5.** A method according to any of the preceding claims **characterized in that** the modulation is a binary phase shift keying (BPSK) modulation with a phase locked loop defined by

$$\varphi_K = \varphi_{k\text{-}1} + \gamma\, \text{Img}\, (y_k\, e^{-i\varphi\,(k\text{-}1)}\ \ \text{th}[\, L_k\, /\, 2 + 2\, /\, \sigma^2\, \text{Re}(y_k\, e^{-i\varphi\,(k\text{-}1)}]\, )$$

where:

th is the hyperbolic tangent operator,
Re is the operator referring to the real part of a complex number,
$\sigma^2$ is the noise variance;
and $L_k = \text{Ln}\,[\, p(a_k = 1)\, /\, p(a_k = -1)]$,

and Ln is the natural logarithm, $p(a_k = 1)$ is the probability that symbol $a_k$ is equal to +1 and $p(a_k = -1)$ is the probability that symbol $a_k$ is equal to -1.

**6.** The method according to claim 5 **characterized in that** said factor is realized by means of a second or higher order digital filter.

**7.** A phase locked loop device for a digital receiver comprising:

- means to receive and store blocks of observations;

**characterized in that** it comprises:

- a first phase locked loop applied on a sequence of observations from said blocks for generating a first intermediate value;
- a second phase locked loop applied on a sequence of observations from said blocks for generating a second intermediate value;
- means to derive a phase estimate from said first and second intermediate values

**8.** The phase locked loop device according to claim 7 **characterized in that** said first and second phase locked loops are realized according to the following formula:

$$\varphi_k = \varphi_{k\text{-}1} - \gamma\, F\, (Y_k\, ,\, \varphi_{k\text{-}1}\, )\ \text{with } k = 1 \text{ to } n$$

or

$$\varphi'_k = \varphi'_{k+1} - \gamma\, F\, (Y_k\, ,\, \varphi'_{k+1}\, )\ \text{with } k = n\text{-}1 \text{ to } 0$$

where F is a function adapted to the type of modulation considered.

**9.** The device according to claim 8 **characterized in that** the first value calculated by said second loop is determined by the last calculation made by said first phase locked loop.

**Patentansprüche**

**1.** Verfahren zur Phasenschätzung in einem digitalen Übertragungssystem, welches folgende Schritte aufweist

- Empfang und Speicherung (11) eines Beobachtungsblocks $Y_k$;

**dadurch gekennzeichnet, dass** er folgende Schritte aufweist:

- Ausführung (12, 13) einer ersten Phasenverriegelungsschleife auf eine aus besagtem Block abgefragte vorgegebene Beobachtungssequenz mit dem Ziel, einen ersten Zwischenwert zu generieren;
- Ausführung (14, 15) einer zweiten Phasenverriegelungsschleife auf besagte Beobachtungen in einer umgekehrten Sequenz mit dem Ziel, einen zweiten Zwischenwert zu generieren;
- Kombination (16) besagter erster und zweiter Zwischenwerte, um einen Schätzwert der Phase zu generieren

2. Verfahren gemäß Anspruch 1, **dadurch gekennzeichnet, dass** die besagte erste Schleife auf der Beobachtungssequenz in chronologischer Reihenfolge des Erscheinens ausgeführt wird und **dadurch**, dass die zweite Sequenz auf der umgekehrten Sequenz ausgeführt wird.

3. Verfahren gemäß Anspruch 2, **dadurch gekennzeichnet, dass** die zweite Phasenverriegelungsschleife ab dem letzten von besagter erster Phasenverriegelungsschleife errechneten Wert initialisiert wird.

4. Verfahren gemäß Anspruch 3, **dadurch gekennzeichnet, dass** es folgende Schritte aufweist:

- Empfang und Speicherung eines Beobachtungsblocks $Y_k$, mit k variiert von 0 bis n;
- Initialisierung einer ersten Phasenverriegelungsschleife ab den erhaltenen Beobachtungen Yk;
- Ausführung der besagten ersten Phasenverriegelungsschleife gemäß einer Formel:

$$\varphi_k = \varphi_{k-1} - \gamma\, F\,(\,Y_k,\, \varphi_{k-1}\,)\ \text{mit } k = 1 \text{ bis } n$$

wobei F eine an den betrachteten Modulationstyp angepasste Funktion ist
- Initialisierung einer zweiten Phasenverriegelungsschleife ab den Beobachtungen Yk, mit k variiert von n bis 0;
- Ausführung der besagten zweiten Phasenverriegelungsschleife gemäß einer Formel:

$$\varphi'_k = \varphi'_{k+1} - \gamma\, F\,(\,Y_k,\, \varphi'_{k+1}\,)\ \text{mit } k = n-1 \text{ bis } 0$$

- Kombination der von den besagten ersten und zweiten Schleifen gelieferten Ergebnisse in einer Weise, dass ein Schätzwert der Phase generiert wird.

5. Verfahren gemäß eines der zuvor dargestellten Ansprüche, **dadurch gekennzeichnet, dass** es sich bei der Modulation um den Typ BPSK mit einer Phasenverriegelungsschleife handelt, die definiert ist durch

$$\varphi_k = \varphi_{k-1} + \gamma\, \mathrm{Img}\,(y_k\, e^{-i\varphi(k-1)}\, \text{th}\,[\,L_k/2 + 2/\sigma^2\, \mathrm{Re}\,(\,y_k\, e^{-i\varphi(k-1)}\,]\,)$$

wobei
th: der hyperbolische Tangentenoperator ist,
Re: der Operator ist, der den Realteil einer komplexen Zahl ausgibt,
$\sigma^2$: die Rauschvarianz ist;
und

$$L_k = \mathrm{Ln}\,[\,p(a_k = 1)\,/\,p(a_k = -1)\,]$$

und wobei Ln der natürliche Logarithmus ist, $p(a_k = 1)$ die Wahrscheinlichkeit dafür ist, dass das Symbol $a_k$ gleich +1 ist und dass $p(a_k = -1)$ die Wahrscheinlichkeit dafür ist, dass das Symbol $a_k$ gleich -1 ist.

6. Verfahren gemäß Anspruch 5, **dadurch gekennzeichnet, dass** der besagte Faktor $\gamma$ mittels eines digitalen Filters der Ordnung 2 oder höher realisiert wird.

**7.** Vorrichtung einer Phasenverriegelungsschleife für einen digitalen Empfänger, die Folgendes aufweist:

- Mittel für den Empfang und die Speicherung von Beobachtungen in Blöcken;

**dadurch gekennzeichnet, dass** sie Folgendes aufweist:

- eine erste Phasenverriegelungsschleife, die auf eine Beobachtungssequenz des besagten Blocks wirkt, wodurch ein erster Zwischenwert generiert werden kann;
- eine zweite Phasenverriegelungsschleife, die in umgekehrter Richtung auf die selbe Beobachtungssequenz des besagten Blocks wirkt, wodurch ein zweiter Zwischenwert generiert werden kann;
- Mittel, um aus besagten ersten und zweiten Zwischenwert einen Schätzwert der Phase abzuleiten.

**8.** Vorrichtung einer Phasenverriegelungsschleife entsprechend Anspruch 7, **dadurch gekennzeichnet, dass** besagte erste und zweite Phasenverriegelungsschleifen mit Hilfe folgender Formel realisiert werden:

$$\varphi_k = \varphi_{k-1} - \gamma F(Y_k, \varphi_{k-1}) \text{ mit } k = 1 \text{ bis } n$$

bzw.

$$\varphi'_k = \varphi'_{k+1} - \gamma F(Y_k, \varphi'_{k+1}) \text{ mit } k = n-1 \text{ bis } 0$$

wobei F eine an den betrachteten Typ der Modulation angepasste Funktion ist.

**9.** Vorrichtung entsprechend Anspruch 8, **dadurch gekennzeichnet, dass** der erste von der besagten zweiten Schleife errechnete Wert von der letzten von besagter erster Phasenverriegelungsschleife durchgeführten Berechnung bestimmt wird.

Mémorisation d'un bloc d'observations $Y_k$ — 11

Initialisation d'une première boucle à verrouillage de phase $\varphi_k$ — 12

Exécution de la première boucle à verrouillage de phase $\varphi_k$ — 13

Initialisation de la seconde boucle à verrouillage de phase $\varphi'_k$ — 14

Execution de la seconde boucle à verrouillage de phase $\varphi'_k$ — 15

Combinaison des résultats intermédiaires $\varphi_k$, $\varphi'_k$ — 16

Fin de traitement du bloc — 17

# Fig.1

$$Y_k = a_k \; e^{\,i\,\xi_k} + \eta_k$$

$\xi_k$

-1

$a_k = +1$

# Fig. 2

1ère boucle à verrouillage

$\varphi_0 \quad \varphi_1 \quad \ldots$ $\qquad\qquad\qquad$ $\varphi_n$

t

$\varphi'_0 \quad \varphi'_1$ $\qquad\qquad$ $\ldots \; \varphi'_n$

2ème boucle à verrouillage

# Fig. 3

Fig. 4

Mémorisation d'un bloc d'observations $Y_k$

51

Initialisation d'une première boucle
à verrouillage de phase $\varphi_k$

52

Exécution de la première boucle

$$\varphi_k = \varphi_{k-1} + \gamma \, \text{Img} \left( y_k \, e^{-i\varphi(k-1)} \, \text{th}[\, L_k \, /2 + 2/\sigma^2 \, \text{Re}(\, y_k \, e^{-i\varphi(k-1)} \,] \,) \right)$$

53

Initialisation de la seconde boucle
à verrouillage de phase $\varphi'_k$

54

Execution de la seconde boucle

$$\varphi_k = \varphi_{k+1} + \gamma \, \text{Img} \left( y_k \, e^{-i\varphi(k+1)} \, \text{th}[\, L_k \, /2 + 2/\sigma^2 \, \text{Re}(\, y_k \, e^{-i\varphi(k+1)} \,] \,) \right)$$

55

Combinaison des résultats intermédiaires
$\varphi_k \, , \, \varphi'_k$

56

Fin de traitement du bloc

57

# Fig. 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 4849991 A